# EUROPEAN PATENT APPLICATION

(11) **EP 4 822 197 A1**
(43) Date of publication of application: **14.10.2026**
(21) Application number: 24915135.8
(22) Date of filing: 23.12.2024
(51) Int. Cl.: F16C 11/04, H05K 7/16, H04M 1/02

(54) **ROTATING SHAFT MECHANISM AND FOLDABLE ELECTRONIC DEVICE**

(30) Priority: 05.01.2024 CN 202410028266
(71) Applicant: Honor Device Co., Ltd., Shenzhen, Guangdong 518040 (CN)
(72) Inventor: SU, Shuai, Shenzhen, Guangdong 518040 (CN); DONG, Shaohong, Shenzhen, Guangdong 518040 (CN); CHEN, Ruihao, Shenzhen, Guangdong 518040 (CN); DAN, Jinqi, Shenzhen, Guangdong 518040 (CN)
(74) Representative: Gill Jennings & Every LLP
(86) International application number: PCT/CN2024/141568
(87) International publication number: WO 2025/145920

(57) **Abstract**

This application discloses a rotating shaft mechanism and a foldable electronic device, and belongs to the field of electronic device technologies. The rotating shaft mechanism includes a base, a first swing arm, and a flexible support structure. There are at least two first swing arms, at least one first swing arm is rotatably mounted on each of two sides of the base, and the first swing arm is capable of rotating relative to the base to enable the rotating shaft mechanism to switch between a folded state and an unfolded state. The flexible support structure includes a flexible portion and a rigid portion, where the flexible portion is located on a side of the base in a thickness direction, the flexible portion has a first surface facing the base, the rigid portion is connected to each of two sides of the first surface, the rigid portion is connected to a corresponding first swing arm, and the flexible portion is configured to form an avoidance space when the rotating shaft mechanism is in a folded state. Disposition of the flexible support structure reduces a quantity of components of the foldable electronic device, thereby improving assembly efficiency of the foldable electronic device.

## Description

This application claims priority to Chinese Patent Application No. 202410028266.0, filed with the China National Intellectual Property Administration on January 5, 2024 and entitled "ROTATING SHAFT MECHANISM AND FOLDABLE ELECTRONIC DEVICE", which is incorporated herein by reference in its entirety.

### TECHNICAL FIELD

This application relates to the field of electronic device technologies, and in particular, to a rotating shaft mechanism and a foldable electronic device.

### BACKGROUND

In recent years, electronic devices have been updated more rapidly, and foldable electronic devices with larger display areas and better portability are increasingly favored by users.

Generally, a foldable electronic device includes a display, a base, and two housings. The two housings are respectively rotatably mounted on two sides of the base through swing arms, and each can rotate relative to the base. The display is disposed on the two housings and the base. When the two housings are rotated so that the two housings face each other, the display is in a folded state. In this case, the foldable electronic device is convenient to carry. When the two housings are rotated so that the two housings are located on a same plane, the display is in an unfolded state. In this case, a display region of the foldable electronic device is large. In a conventional technology, a plurality of support structures are mounted on two sides of a base, and the support structures can move relative to the base, so that a display is supported when a foldable electronic device is in an unfolded state, and an avoidance space is formed when the foldable electronic device is in a folded state, thereby facilitating accommodation of a bent region of the display.

However, an existing foldable electronic device has a complex structure and low assembly efficiency.

### SUMMARY

This application provides a rotating shaft mechanism and a foldable electronic device. The rotating shaft mechanism can support a display through a flexible support member, thereby simplifying a structure of the rotating shaft mechanism and improving assembly efficiency.

The technical solutions are as follows:
A first aspect of this application provides a rotating shaft mechanism, including:
a base;
a first swing arm, where there are at least two first swing arms, at least one first swing arm is rotatably mounted on each of two sides of the base, and the first swing arm is capable of rotating relative to the base to enable the rotating shaft mechanism to switch between a folded state and an unfolded state; and
a flexible support structure, including a flexible portion and a rigid portion, where the flexible portion is located on a side of the base in a thickness direction, the flexible portion has a first surface facing the base, the rigid portion is connected to each of two sides of the first surface, the rigid portion is connected to a corresponding first swing arm, and the flexible portion is configured to form an avoidance space when the rotating shaft mechanism is in a folded state.

The rotating shaft mechanism is used in a foldable electronic device. When the foldable electronic device is in an unfolded state, the flexible portion of the flexible support structure supports a display. When the foldable electronic device is in a folded state, the first swing arm swings relative to the base, to drive the rigid portion to swing, and the rigid portion drives the flexible portion to bend from each of two sides of the flexible portion, so that the flexible portion is bent to form the avoidance space, and a bent region in the middle of the display is located in the avoidance space. The rotating shaft mechanism can support the display in an unfolded state and form the avoidance space in a folded state by disposing the flexible support structure, thereby reducing a quantity of components of the foldable electronic device, simplifying an assembly process of the foldable electronic device, and improving assembly efficiency of the foldable electronic device.

In some possible designs, the rotating shaft mechanism further includes a fixing member, and the rigid portion and the first swing arm are connected through the fixing member. The rigid portion is provided with a first fixing hole, the first swing arm is provided with a second fixing hole, and the fixing member passes through the first fixing hole and the second fixing hole to connect the rigid portion to the first swing arm.

In some possible designs, the rigid portion includes a support plate and a fixing base, the fixing base is connected to the support plate, the fixing base is provided with a fixing column, the first fixing hole is provided on the fixing column, and at least a part of the fixing column extends into the second fixing hole.

In some possible designs, the support plate and the fixing base are limited and fixed to some extent. Specifically, the fixing base is provided with a positioning member, the support plate is provided with a first positioning hole, at least a part of the positioning member is located in the first positioning hole, and the support plate limits the positioning member to some extent through the first positioning hole, to limit the fixing base to some extent.

In some possible designs, the flexible portion is provided with a second positioning hole, and the second positioning hole is disposed opposite to the first positioning hole.

In some possible designs, the first fixing hole is a threaded hole, the second fixing hole is a countersunk hole, the fixing member includes a head and a threaded portion that are connected to each other, the head is located in the countersunk hole, and the threaded portion is located in the threaded hole. The threaded portion of the fixing member passes through the countersunk hole and then is screwed into the threaded hole, and the fixing member is connected to the support plate through threaded engagement between the threaded portion and the threaded hole. Because the head of the fixing member is located in the countersunk hole, the fixing member connects the fixing base to the support plate.

In some possible designs, the rigid portion and the flexible portion may be adhered with adhesive. For example, the rigid portion has a second surface facing the first surface, and the second surface is provided with an adhesive accommodating groove. The adhesive accommodating groove may be used for adhesive accommodation, and the adhesive is used to connect the rigid portion to the flexible portion.

In some possible designs, the second surface is provided with an adhesive overflow groove, and the adhesive overflow groove communicates with the adhesive accommodating groove. If there is too much adhesive in the adhesive accommodating groove or after adhesive expands, the adhesive may enter the adhesive overflow groove.

In some possible designs, an avoidance opening is disposed at an edge of the rigid portion. The avoidance opening may be disposed for avoiding the first swing arm or another structure mounted on the base.

In some possible designs, the rigid portion is provided with a weight-reducing hole. Disposition of the weight-reducing hole reduces a weight of the rigid portion.

In some possible designs, a plurality of hole structures are disposed on the flexible portion, a length direction of the hole structure is a first direction, and the first direction is parallel to a rotation axis of the first swing arm. Disposition of the hole structure can reduce internal stress of the flexible portion in a bending process, thereby facilitating bending of the flexible portion.

In some possible designs, the flexible portion is provided with a plurality of hole structures spaced apart in the first direction, the plurality of hole structures spaced apart in the first direction form one hole group, the flexible support structure is provided with a plurality of hole groups spaced apart in a second direction, and the second direction is at an angle to the first direction.

In some possible designs, hole structures in two adjacent hole groups are staggered at a center point of the first direction.

In some possible designs, the hole structure penetrates the flexible portion in a thickness direction of the flexible portion. The hole structure penetrating the flexible portion facilitates production and processing.

In some possible designs, the rotating shaft mechanism is further provided with an adapter structure, the adapter structure is slidably connected to the first swing arm, the adapter structure is rotatably connected to the base, and the adapter structure is configured to drive the first swing arm to rotate and make a rotation angle of the first swing arm greater than a rotation angle of the adapter structure, so that the flexible portion bends under driving of the first swing arm to form a water-drop-shaped avoidance space. The water-drop-shaped avoidance space is more conducive to protecting the display.

In some possible designs, the adapter structure is provided with a first sliding hole, the first swing arm is provided with a first sliding portion, and the first sliding portion is slidably assembled in the first sliding hole.

In some possible designs, the first swing arm includes a first swing body and the first sliding portion, the first swing body is provided with a first through-hole, the first sliding portion passes through the first through-hole and is connected to the first swing body, and at least a part of structure that is of the first sliding portion and that is located outside the first through-hole is located in the first sliding hole.

In some possible designs, there are two first through-holes, the two first through-holes are respectively located on two sides of the first sliding hole, the two first through-holes are coaxially disposed, and two ends of the first sliding portion are respectively located in the two first through-holes.

In some possible designs, the first swing body is provided with a first swing portion, the base is provided with a first swing groove, the first swing portion is slidably assembled in the first swing groove, and the first swing portion is capable of sliding relative to the first swing groove to enable the first swing body to swing.

A second aspect of this application provides a foldable electronic device, including a first housing, a second housing, a display, and the rotating shaft mechanism provided in any one of the foregoing technical solutions. The rotating shaft mechanism is connected between the first housing and the second housing, the display is disposed on one side of the first housing, the second housing, and the rotating shaft mechanism, the display is located on a side that is of the flexible portion and that is away from the base in the rotating shaft mechanism, and at least a part of the display is located in the avoidance space when the rotating shaft mechanism is in a folded state.

According to the foregoing technical solutions, because the foldable electronic device includes the foregoing rotating shaft mechanism, the foldable electronic device has at least all beneficial effects of the rotating shaft mechanism. Details are not described herein again.

### BRIEF DESCRIPTION OF THE DRAWINGS

FIG. 1 is a diagram of a structure of a foldable electronic device in a folded state according to an embodiment of this application;
FIG. 2 is a diagram of a structure of a foldable electronic device in a semi-folded state according to an embodiment of this application;
FIG. 3 is a diagram of a structure of a foldable electronic device in an unfolded state according to an embodiment of this application;
FIG. 4 is a diagram of an exploded structure of the foldable electronic device shown in FIG. 3;
FIG. 5 is a diagram of a structure of a rotating shaft mechanism in an unfolded state according to an embodiment of this application;
FIG. 6 is an exploded component view of a rotating shaft mechanism according to an embodiment of this application;
FIG. 7 is a sectional view of G-G in FIG. 5;
FIG. 8 is a sectional view of the rotating shaft mechanism shown in FIG. 7 in a folded state;
FIG. 9 is an exploded component view of a first swing arm and an adapter structure in a rotating shaft mechanism according to an embodiment of this application;
FIG. 10 is a partially enlarged view of B in FIG. 6;
FIG. 11 is an exploded component view of a flexible support structure in a rotating shaft mechanism from a perspective according to an embodiment of this application;
FIG. 12 is a partially enlarged view of C in FIG. 11;
FIG. 13 is an exploded component view of a flexible support structure in a rotating shaft mechanism from another perspective according to an embodiment of this application;
FIG. 14 is a partially enlarged view of D in FIG. 13;
FIG. 15 is a partially enlarged view of A in FIG. 5;
FIG. 16 is a sectional view of F-F in FIG. 5;
FIG. 17 is a sectional view of the rotating shaft mechanism shown in FIG. 16 in a folded state;
FIG. 18 is a diagram of a structure of a flexible support structure in a rotating shaft mechanism according to an embodiment of this application; and
FIG. 19 is a partially enlarged view of E in FIG. 18.

Descriptions of reference numerals are as follows:
1-foldable electronic device;
10-rotating shaft mechanism; 20-first housing; 30-second housing; 40-display; 41-first part; 42-second part; and 43-foldable part;
100-base; and 110-first swing groove;
210-first swing arm; 211-second fixing hole; 213-first swing body; 2131-first through-hole; 2132-first swing portion; 214-first sliding portion; 220-second swing arm; 230-third swing arm; 240-adapter structure; and 241-first sliding hole;
300-flexible support structure; 310-avoidance space; 320-flexible portion; 321-first surface; 322-second positioning hole; 323-hole structure; and 3231-center point;
330-rigid portion; 331-support plate; 3311-second surface; 3312-adhesive accommodating groove; 3313-adhesive overflow groove; 3314-avoidance hole; 3315-weight-reducing hole; 3316-first positioning hole; 332-fixing base; 3321-first fixing hole; 3322-fixing column; and 3323-positioning member; and
400-fixing member; 410-header; and 420-threaded portion.

### DESCRIPTION OF EMBODIMENTS

To make the objectives, technical solutions, and advantages of this application clearer, the following further describes implementations of this application in detail with reference to the accompanying drawings.

It should be understood that "a plurality of" mentioned in this application means two or more. In descriptions of this application, unless otherwise specified, "/" means "or". For example, A/B may indicate A or B. In this specification, "and/or" describes only an association relationship for describing associated objects and indicates that three relationships may exist. For example, A and/or B may indicate the following three cases: Only A exists, both A and B exist, and only B exists. In addition, to clearly describe the technical solutions of this application, words such as "first" and "second" are used to distinguish same items or similar items with basically same functions and effects. A person skilled in the art may understand that the words such as "first" and "second" do not limit a quantity or an execution sequence, and the words such as "first" and "second" do not indicate a definite difference.

A rotating shaft mechanism and a foldable electronic device provided in embodiments of this application are explained and described in detail below. In the accompanying drawings of this application, a lead with a hollow arrow points to a surface of a device, a lead with a round point points to a space region within a particular range such as a hole, a groove, or a cavity, and a lead with a solid arrow points to a device itself.

A foldable electronic device 1 includes but is not limited to a cellphone (cellphone), a notebook computer (notebook computer), a tablet personal computer (tablet personal computer), a laptop computer (laptop computer), a personal digital assistant (personal digital assistant), a wearable device (wearable device), a vehicle-mounted device (mobile device), or the like. In embodiments of this application, an example in which the foldable electronic device 1 is a cellphone is used for description.

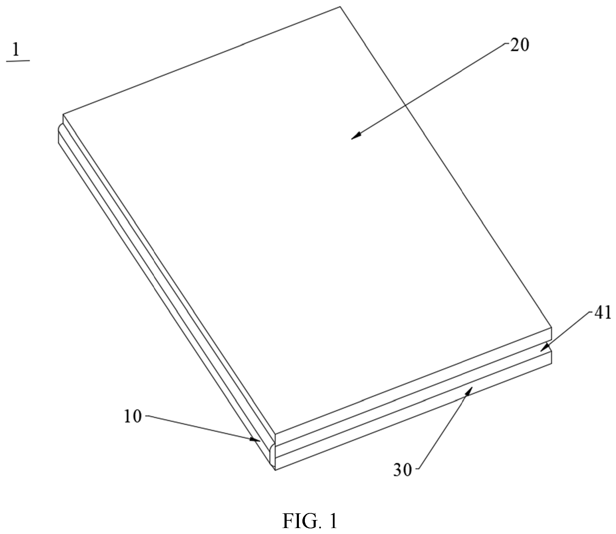

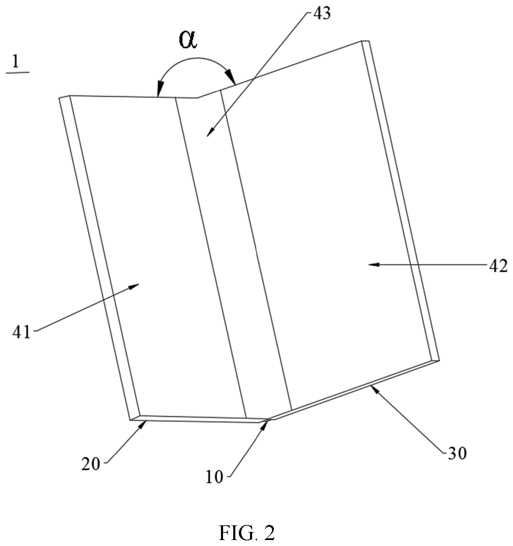

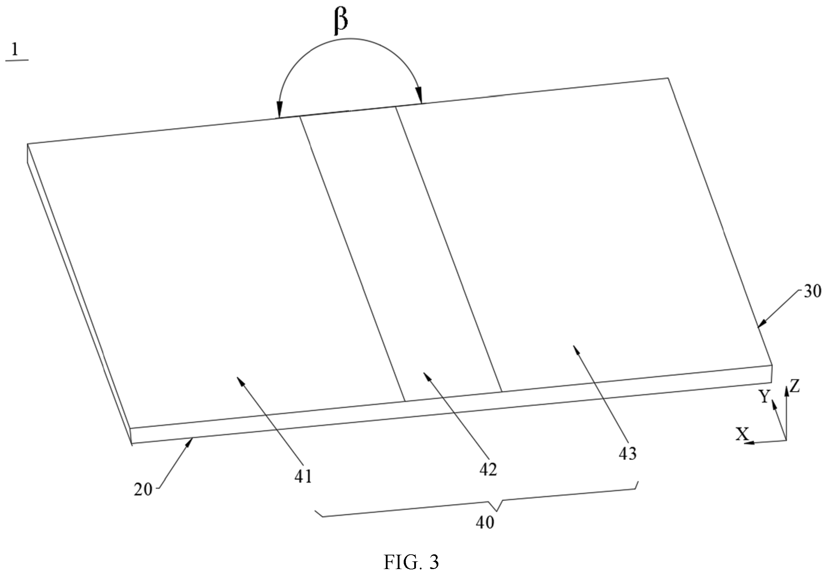

The foldable electronic device 1 is in a folded state in FIG. 1, the foldable electronic device 1 is in a semi-folded state in FIG. 2, and the foldable electronic device 1 is in an unfolded state in FIG. 3. An unfolding angle α of the foldable electronic device 1 shown in FIG. 2 is 90 degrees, and an unfolding angle β of the foldable electronic device 1 shown in FIG. 3 is 180 degrees.

It should be noted that a slight deviation is allowed for each angle used as an example in embodiments of this application. For example, that the unfolding angle α of the foldable electronic device 1 shown in FIG. 2 is 90 degrees means that α may be 90 degrees or approximately 90 degrees, such as 80 degrees, 85 degrees, 95 degrees, or 100 degrees. That the unfolding angle β of the foldable electronic device 1 shown in FIG. 3 is 180 degrees means that β may be 180 degrees or approximately 180 degrees, such as 170 degrees, 175 degrees, 185 degrees, or 190 degrees. An angle used as an example below may be understood in the same way.

The foldable electronic device 1 shown in embodiments of this application is an electronic device that can be folded once. In some other embodiments, the foldable electronic device 1 may alternatively be an electronic device that can be folded a plurality of times (more than twice). In this case, the foldable electronic device 1 may include a plurality of parts, two adjacent parts may be folded relatively close to each other until the foldable electronic device 1 is in a folded state, and two adjacent parts may be unfolded relatively away from each other until the foldable electronic device 1 is in an unfolded state.

For ease of description, a width direction of the foldable electronic device 1 is defined as an X-axis direction, a length direction of the foldable electronic device 1 is defined as a Y-axis direction, and a thickness direction of the foldable electronic device 1 is defined as a Z-axis direction. The X-axis direction, the Y-axis direction, and the Z-axis direction are mutually perpendicular to each other. It should be noted that a dimension in the width direction is not necessarily greater than a dimension in the length direction. It should be noted that qualifiers such as parallel and perpendicular for relative positional relationships in embodiments are all for a current process level and are not absolutely strict definitions in a mathematical sense. A slight deviation is allowed, and "approximately parallel" and "approximately perpendicular" are both acceptable. For example, that A is parallel to B means that A is parallel or approximately parallel to B, and an included angle between A and B is between 0 degrees and 10 degrees. For example, that A is perpendicular to B means that A is perpendicular or approximately perpendicular to B, and an included angle between A and B is between 80 degrees and 100 degrees. Orientation words such as "top", "bottom", "left", "right", "front", and "rear" used in embodiments to describe the foldable electronic device 1 are mainly described based on a display orientation of the foldable terminal in FIG. 3, with "top" facing a positive direction of a Y axis, "bottom" facing a negative direction of the Y axis, "left" facing a positive direction of an X axis, "right" facing a negative direction of the X axis, "front" facing a positive direction of a Z axis, and "rear" facing a negative direction of the Z axis.

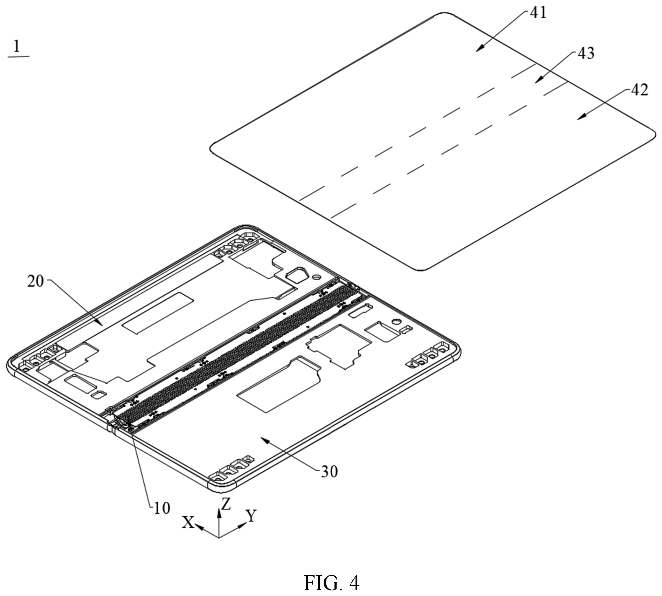

FIG. 4 is a diagram of an exploded structure of the foldable electronic device 1 shown in FIG. 3. The foldable electronic device 1 includes a first housing 20, a second housing 30, a rotating shaft mechanism 10, and a display 40. The rotating shaft mechanism 10 is connected between the first housing 20 and the second housing 30. Specifically, the first housing 20 and the second housing 30 are respectively mounted on two sides of the rotating shaft mechanism 10 in a width direction. In other words, the first housing 20 and the second housing 30 are respectively mounted on left and right sides of the rotating shaft mechanism 10. The first housing 20 and the second housing 30 rotate relative to each other through the rotating shaft mechanism 10. Rotation directions of the first housing 20 and the second housing 30 are opposite. The display 40 is disposed on one side of the first housing 20, the second housing 30, and the rotating shaft mechanism 10. Specifically, the display 40 is disposed on a front side of the first housing 20, the second housing 30, and the rotating shaft mechanism 10. The display 40 includes a first part 41, a second part 42, and a foldable part 43. The foldable part 43 is located between the first part 41 and the second part 42, and the foldable part 43 may be bent in a Y-axis direction. The first part 41, the second part 42, and the foldable part 43 jointly form the display 40. In embodiments, the display 40 is a flexible display 40, for example, an organic light-emitting diode (organic light-emitting diode, OLED) display 40, an active-matrix organic light-emitting diode or an active-matrix organic light-emitting diode (active-matrix organic light-emitting diode, AMOLED) display 40, a mini light-emitting diode (mini organic lightemitting diode) display 40, a micro light-emitting diode (micro organic light-emitting diode) display 40, a micro organic light-emitting diode (micro organic light-emitting diode) display 40, or a quantum dot light-emitting diode (quantum dot light emitting diodes, QLED) display 40.

The first housing 20 and the second housing 30 move relatively close to each other to drive the display 40 to fold, so that the foldable electronic device 1 is folded. When the foldable electronic device 1 is in a folded state, the foldable part 43 of the display 40 is bent, and the first part 41 and the second part 42 are disposed opposite to each other. In this case, the display 40 is located between the first housing 20 and the second housing 30, so that a probability of the display 40 being damaged can be greatly reduced, thereby effectively protecting the display 40.

Refer to FIG. 2 and FIG. 4 together. The first housing 20 and the second housing 30 rotate relative to each other through the rotating shaft mechanism 10, and the first housing 20 and the second housing 30 move relatively away from each other to drive the display 40 to unfold, so that the foldable electronic device 1 is unfolded to a semi-folded state. When the foldable electronic device 1 is in a semi-folded state, the first housing 20 and the second housing 30 are unfolded to an angle α, and the first part 41 and the second part 42 are relatively unfolded, and drive the foldable part 43 to unfold. In this case, an angle between the first part 41 and the second part 42 is α.

Refer to FIG. 3 and FIG. 4 together. The first housing 20 and the second housing 30 rotate relative to each other through the rotating shaft mechanism 10. The first housing 20 and the second housing 30 may use a same structure, and the first housing 20 and the second housing 30 may be disposed in mirror symmetry relative to the rotating shaft mechanism 10. The first housing 20 and the second housing 30 move relatively away from each other to drive the display 40 to further unfold until the foldable electronic device 1 is flattened. When the foldable electronic device 1 is in a flattened state, an angle between the first housing 20 and the second housing 30 is β. The foldable part 43 is unfolded, and the first part 41 and the second part 42 are relatively unfolded. In this case, angles between the first part 41, the second part 42, and the foldable part 43 are all β, and the display 40 has a display region with a large area, so that large-screen display on the foldable electronic device 1 is implemented, and user experience is improved. It should be noted that the angle α and the angle β are both angles between the first housing 20 and the second housing 30, and are merely used herein to distinguish between different angles between the first housing 20 and the second housing 30 in different states of the foldable electronic device 1. The angle α is an angle between the first housing 20 and the second housing 30 when the foldable electronic device 1 is in a semi-folded state. The angle β is an angle between the first housing 20 and the second housing 30 when the foldable electronic device 1 is in an unfolded state.

It should be understood that the foldable electronic device 1 in embodiments of this application is folded inward, and the display 40 of the foldable electronic device 1 in a folded state is located on an inner side of the rotating shaft mechanism 10. In some other embodiments, the foldable electronic device 1 may alternatively be folded outward. In this case, the display 40 of the foldable electronic device 1 in a folded state is located on an outer side of the rotating shaft mechanism 10.

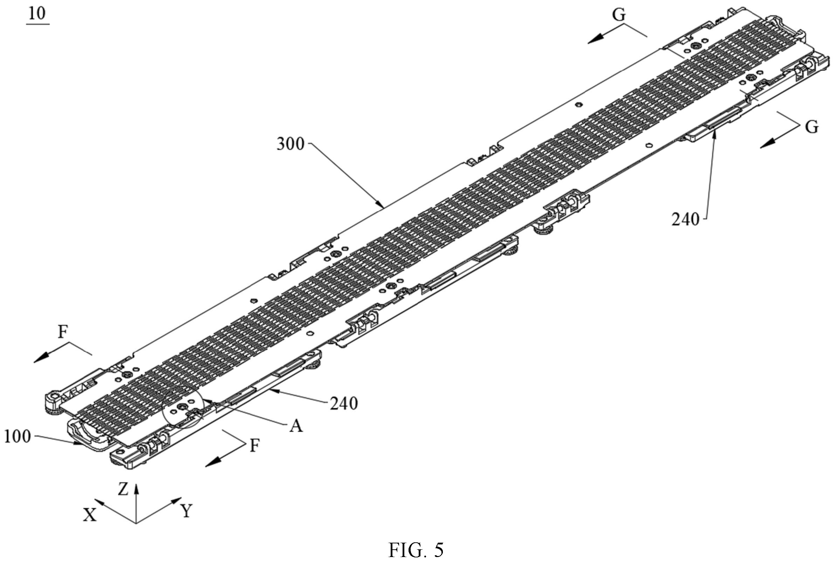

As shown in FIG. 5, in this embodiment, the rotating shaft mechanism 10 includes a base 100, a first swing arm 210, and a flexible support structure 300. There are at least two first swing arms 210, so that at least onefirst swing arm 210 is connected to each of two sides of the base 100 in a width direction. The first swing arm 210 is rotatably connected to the base 100, the first swing arm 210 can rotate relative to the base 100, and rotation directions of the first swing arms 210 located on the two sides of the base 100 are opposite. The first swing arm 210 rotates relative to the base 100 to enable the rotating shaft mechanism 10 to switch between a folded state and an unfolded state. It should be noted that when the rotating shaft mechanism 10 is in a folded state, the foldable electronic device 1 using the rotating shaft mechanism 10 is in a folded state. When the rotating shaft mechanism is in an unfolded state, the foldable electronic device 1 using the rotating shaft mechanism 10 is in an unfolded state. The flexible support structure 300 includes a flexible portion 320 and a rigid portion 330. The rigid portion 330 is more rigid than the flexible portion 320, so that under same force, the flexible portion 320 is more easily deformed than the rigid portion 330. The rigid portion 330 supports the flexible portion 320. The flexible portion 320 is located on a side of the base 100 in a thickness direction, the flexible portion 320 has a first surface 321, and the first surface 321 includes a region that is of the flexible portion 320 and that faces the base 100. The rigid portion 330 is disposed on each of two sides of the first surface 321, and the rigid portion 330 is connected to a corresponding first swing arm 210. In other words, the rigid portion 330 and the first swing arm 210 located on a same side of the base 100 are connected. The first swing arms 210 located on the two sides of the base 100 swing to drive the rigid portions 330 to swing. The rigid portions 330 are connected to the flexible portion 320. The rigid portions 330 located on two sides of the flexible portion 320 respectively drive two ends of the flexible portion 320 to swing, thereby causing the flexible portion 320 to bend. After the flexible portion 320 is bent, an avoidance space 310 is formed. The avoidance space 310 is used to accommodate the foldable part 43 of the display 40.

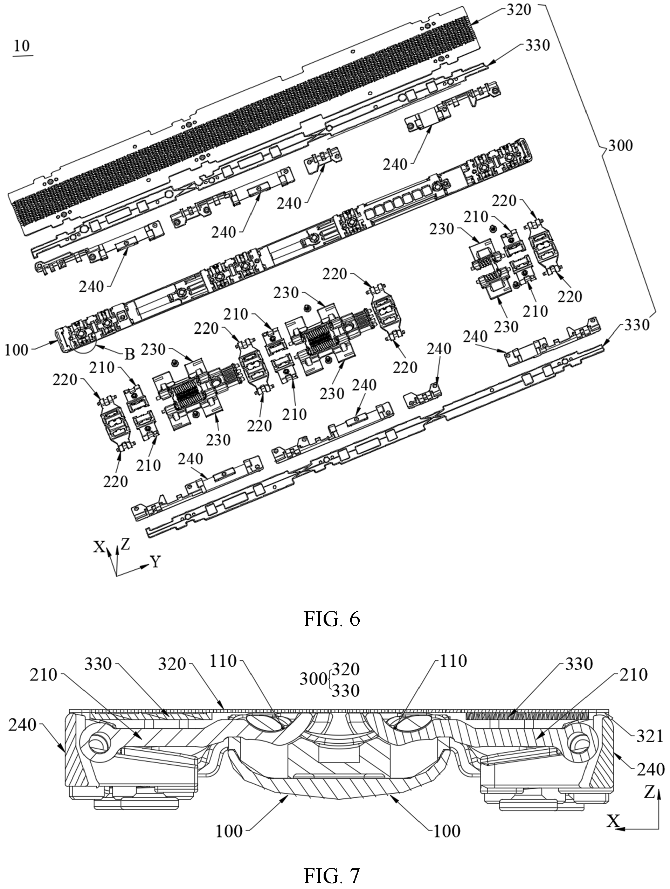

Specifically, as shown in FIG. 5 and FIG. 6, a first swing arm 210 is disposed on each of left and right sides of the base 100. In FIG. 6, there are six first swing arms 210, three first swing arms 210 are disposed on each of the left side and the right side of the base 100, first swing arms 210 located on a same side are spaced apart in a length direction of the base 100, and the three first swing arms 210 located on the left side are symmetrically arranged with the three first swing arms 210 located on the right side. If a first swing arm 210 located on the left side and another first swing arm 210 symmetrically arranged with the first swing arm 210 are referred to as a first arm set, in FIG. 6, in the length direction of the base 100, a first arm set is disposed in a region near the top of the base 100, a first arm set is disposed in a region near the bottom, and a first arm set is disposed in a middle region of the base 100.

The flexible portion 320 is located on a front side of the base 100 and the first swing arm 210. In the width direction, a middle region of the flexible portion 320 is located on a front side of the base 100, a left region of the flexible portion 320 is located on a front side of the first swing arm 210 on the left side of the base 100, and a right region of the flexible portion 320 is located on a front side of the first swing arm 210 on the right side of the base 100.

In a specific example, the flexible portion 320 is a plate-like structure that is elastic and bendable. The rigid portion 330 is of a strip-shaped plate-like structure. Compared with the flexible portion 320, the rigid portion 330 is less prone to bending or deformation. The flexible portion 320 may be made of an elastic steel sheet, and the rigid portion 330 may be made of a steel sheet or a plastic sheet with greater rigidity than the flexible portion 320. Both the steel sheet and the plastic sheet have good flatness, and provide good support for the display 40. The flexible portion 320 has a first surface 321, and the first surface 321 faces the base 100. In other words, a rear side of the flexible portion 320 is the first surface 321. A rigid portion 330 is disposed on each of left and right sides of the first surface 321. The rigid portion 330 located in the left region of the first surface 321 is located between the flexible portion 320 and a first swing arm 210 on a left side of the base 100, and the rigid portion 330 located in the right region of the first surface 321 is located between the flexible portion 320 and a first swing arm 210 on a right side of the base 100. The rigid portion 330 is connected to the first swing arm 210, and the rigid portion 330 is connected to the flexible portion 320. At least one rigid portion 330 may be disposed on one side of the flexible portion 320 in a length direction, and the rigid portion 330 is located between the flexible portion 320 and the first swing arm 210. When a plurality of first swing arms 210 are disposed on one side of the flexible portion 320, there may be one or more rigid portions 330. For example, in FIG. 6, one first swing arm 210 is disposed on each of the left and right sides of the flexible portion 320, and one rigid portion 330 is disposed on each of the left and right sides of the flexible portion 320. The rigid portion 330 is of a strip-shaped plate-like structure. The rigid portion 330 extends in the length direction of the base 100. A length of the rigid portion 330 is the same as or approximate to a length of the flexible portion 320. The three first swing arms 210 located on the left side of the base 100 each are connected to the rigid portion 330 located on the left side, and the three first swing arms 210 located on the right side of the base 100 each are connected to the rigid portion 330 located on the right side.

When the rotating shaft mechanism 10 is used in the foldable electronic device 1, the display 40 is disposed on a side (the front side) of the rotating shaft mechanism 10, and the foldable part 43 of the display 40 is located on a side that is of the flexible portion 320 and that is away from the base 100. When the rotating shaft mechanism 10 is in an unfolded state, the side that is of the flexible portion 320 and that is away from the base 100 is planar or approximately planar, and the flexible portion 320 supports the display 40. The rigid portion 330 is located between the flexible portion 320 and the first swing arm 210. When the first swing arm 210 drives the flexible portion 320 to bend, one or more first swing arms 210 on a same side apply force to the flexible portion 320 through the rigid portion 330. Compared with direct contact between the first swing arm 210 and the flexible portion 320, disposition of the rigid portion 330 may enable the flexible portion 320 to bear more even force in the length direction, thereby facilitating bending of the flexible portion 320 in a specified bending direction. After the flexible portion 320 is bent, an avoidance space 310 is enclosed, and at least the foldable part 43 of the display 40 is located in the avoidance space 310. The avoidance space 310 is disposed, so that a bending angle of the foldable part 43 of the display 40 is relatively larger, thereby making it less prone to creases and helping protect the display 40.

When the foldable electronic device 1 is in an unfolded state, the flexible portion 320 of the flexible support structure 300 supports the display 40. When the foldable electronic device 1 is in a folded state, the first swing arm 210 swings relative to the base 100, to drive the rigid portion 330 to swing, and the rigid portion 330 drives the flexible portion 320 to bend from each of two sides of the flexible portion 320, so that the flexible portion 320 is bent to form the avoidance space 310, and a bent region in the middle of the display 40 is located in the avoidance space 310. Compared with a conventional technology in which a plurality of structures that can move relative to a base are disposed to support a display and form an avoidance space, the flexible support structure 300 deforms to transform between a flat shape and a bent shape, when the flexible support structure 300 is in a flat shape, the flexible support structure may better support the display 40, and when the flexible support structure is in a bent shape, the avoidance space 310 is formed for accommodating at least a part of structure of the display 40. It can be learned from the foregoing descriptions that a connection structure capable of movement such as rotation, swing, or sliding does not need to be disposed on the flexible support structure 300 or a connection between the flexible support structure 300 and the first swing arm 210. In this embodiment, the flexible support structure 300 is fixedly connected to the first swing arm 210. Compared with a connection structure capable of relative movement, a structure requiring only a fixed connection is simple, thereby simplifying an assembly process of the foldable electronic device 1 and improving assembly efficiency of the foldable electronic device 1.

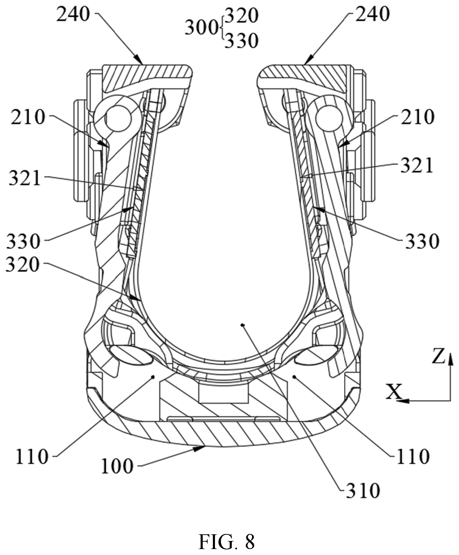

As shown in FIG. 7 and FIG. 8, the avoidance space 310 formed after the flexible portion 320 is bent may be U-shaped or water-drop-shaped. The first swing arm 210 is in transmission connection with the first housing 20 or the second housing 30 opposite to the first swing arm 210. The first housing 20 and the second housing 30 swing relative to each other, to drive the first swing arms 210 on two sides of the base 100 to swing relative to each other. In some examples, the rotating shaft mechanism 10 further includes an adapter structure 240, the adapter structure 240 is rotatably connected to the base 100, the first swing arm 210 is connected to the corresponding first housing 20 or second housing 30 through the adapter structure 240, and the first swing arm 210 and the adapter structure 240 are slidably assembled, so that a swing angle of the first swing arm 210 is different from a swing angle of the corresponding first housing 20 or second housing 30. In this way, the flexible portion 320 is bent through the first swing arm 210 to form the water-drop-shaped avoidance space 310. For example, the first swing arm 210 rotates about a first axis, the adapter structure 240 rotates about a second axis, the first axis and the second axis are both parallel to the length direction of the base 100, a plane on which a rear side of the base 100 is located is used as a reference plane, and a distance between the first axis and the reference plane is greater than a distance between the second axis and the reference plane. For example, when the first housing 20 rotates by 90°, a rotation angle of the first swing arm 210 may be 92° to 110°, for example, the rotation angle of the first swing arm 210 may be 95°, 98°, 100°, or 102°.

In some embodiments, the rotating shaft mechanism 10 is further provided with a second swing arm 220, the second swing arm 220 is rotatably connected to the base 100, the adapter structure 240 may be rotatably connected to the second swing arm 220, and the adapter structure 240 may be rotatably connected to the base 100 through the second swing arm 220.

It should be noted that when the rotating shaft mechanism 10 is provided with the first swing arm 210, the second swing arm 220, and the adapter structure 240, the first swing arm 210, the second swing arm 220, and the adapter structure 240 are not necessarily in transmission connection. The first swing arm 210 may be independently slidably connected to the adapter structure 240, and the second swing arm 220 may also be independently slidably connected to the adapter structure 240. The first swing arm 210 and the second swing arm 220 may also be in transmission connection with a same adapter structure 240.

In some feasible implementations, the rotating shaft mechanism 10 is further provided with a third swing arm 230, the rotating shaft mechanism 10 may be further provided with a damping structure or a synchronization structure, and the third swing arm 230 is in transmission connection with the damping structure or the synchronization structure. The third swing arm 230 is in transmission connection with the corresponding first housing 20 or second housing 30. The third swing arm 230 may also be in transmission connection with the corresponding first housing 20 or second housing 30 through the adapter structure 240.

In a specific implementation, first swing arms 210, second swing arms 220, third swing arms 230, and adapter structures 240 disposed on the left side and the right side of the base 100 are of a same quantity and are symmetrically located. On the left side of the base 100, four adapter structures 240, four second swing arms 220, three first swing arms 210, and three third swing arms 230 are disposed, one of the adapter structures 240 is rotatably connected to one second swing arm 220, three adapter structures 240, three second swing arms 220, three third swing arms 230, and three first swing arms 210 are divided into three groups, and each group includes one adapter structure 240, one first swing arm 210, one second swing arm 220, and one third swing arm 230. The adapter structure 240 is slidably connected to the first swing arm 210, the adapter structure 240 is rotatably connected to the second swing arm 220, and the adapter structure 240 is slidably connected to the third swing arm 230, that is, a first swing arm 210, a second swing arm 220, and a third swing arm 230 of a same group are in transmission connection with a same adapter structure 240.

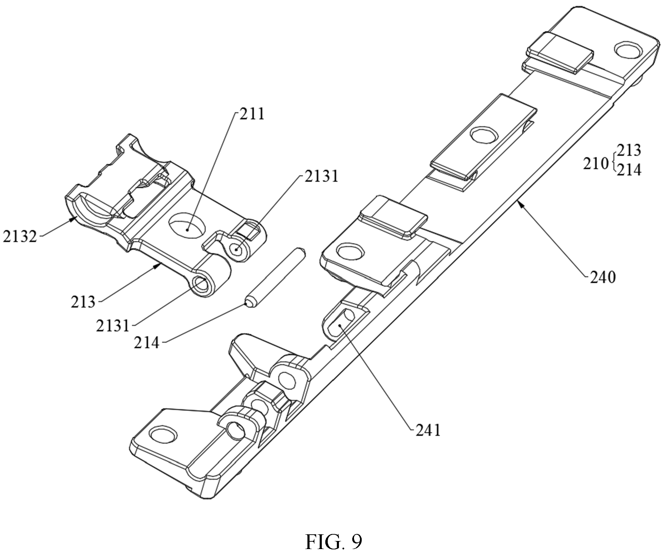

The first swing arm 210 and the adapter structure 240 are slidably assembled, that is, in a process in which the first swing arm 210 and the adapter structure 240 separately rotate relative to the base 100, the first swing arm 210 and the adapter structure 240 may slide relative to each other. As shown in FIG. 9, in some setting manners, the adapter structure 240 is provided with a first sliding hole 241, the first swing arm 210 is provided with a first sliding portion 214, and the first sliding portion 214 is slidably assembled in the first sliding hole 241. An extension direction of the first sliding hole 241 may be set based on a moving track of the first sliding portion 214 relative to the adapter structure 240 in a swing process of the first swing arm 210 and the adapter structure 240. For example, when the moving track of the first sliding portion 214 on the adapter structure 240 is arc-shaped, the first sliding hole 241 is an arc-shaped hole. When the moving track of the first sliding portion 214 on the adapter structure 240 is straight, the first sliding hole 241 may be an elongated hole that extends along a straight line. In FIG. 9, the first sliding hole 241 is an elongated hole.

A first swing body 213 and the first sliding portion 214 may be of an integrated structure and are manufactured through integrated molding. In other words, a part of structure that is in the first swing arm 210 and that cooperates with the first sliding hole 241 is referred to as the first sliding portion 214, and the other part of structure is referred to as the first swing body 213. In another implementation, the first swing body 213 and the first sliding portion 214 are two independent structures, the two structures are independently produced and manufactured, and the first swing body 213 and the first sliding portion 214 are fixedly connected. The first swing body 213 and the first sliding portion 214 may be connected through interference fit connection, adhesion, welding, bolting, or the like.

In some implementations, the first swing arm 210 includes a first swing body 213 and the first sliding portion 214, the first swing body 213 is provided with a first through-hole 2131, the first sliding portion 214 passes through the first through-hole 2131 and is connected to the first swing body 213, and at least a part of structure that is of the first sliding portion 214 and that is located outside the first through-hole 2131 is located in the first sliding hole 241. In this setting manner, because the first swing body 213 and the first sliding portion 214 are two independent structures, the structures of the first swing body 213 and the first sliding portion 214 are both simpler, thereby facilitating production and manufacture. Because the first swing body 213 is provided with the first through-hole 2131, and the first sliding portion 214 partially passes through the first through-hole 2131, the first swing body 213 limits the first sliding portion 214 to some extent through the first through-hole 2131, thereby facilitating connection between the first swing body 213 and the first sliding portion 214. For example, the first sliding portion 214 and the first through-hole 2131 may be in interference fit connection. Alternatively, the first sliding portion 214 may extend into the first through-hole 2131 after being applied with adhesive, so that the first sliding portion 214 is adhered to an inner wall of the first through-hole 2131. Alternatively, after the first sliding portion 214 extends into the first through-hole 2131, the first sliding portion 214 may be welded and fixed to the first swing body 213. The first sliding portion 214 may be a cylindrical rod-shaped structure, and the first through-hole 2131 is a circular hole and a through-hole. An axis of the first sliding portion 214 is parallel to the first axis.

There are two first through-holes 2131, the two first through-holes 2131 are respectively located on two sides of the first sliding hole 241, the two first through-holes 2131 are coaxially disposed, and two ends of the first sliding portion 214 are respectively located in the two first through-holes 2131. In this setting manner, the two ends of the first sliding portion 214 are respectively limited by hole walls of the two first through-holes 2131, so that the first swing body 213 has better limiting effect for the first sliding portion 214, thereby helping improve strength of connection between the first sliding portion 214 and the first swing body 213.

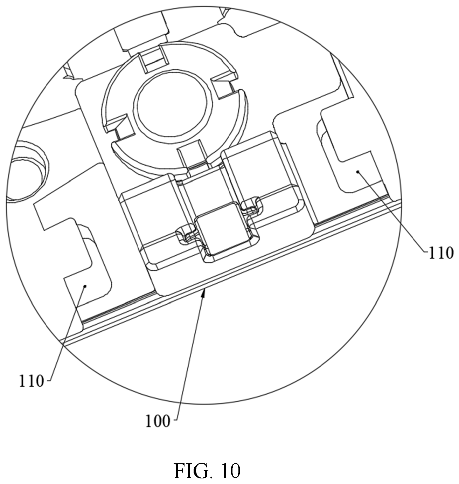

The first swing arm 210 is rotatably connected to the base 100. The first swing arm 210 may be rotatably connected to the base 100 through a rotation axis, or the first swing arm 210 may be rotatably connected to the base 100 through a virtual axis structure. The virtual axis structure is that no physical rotation axis is disposed between the first swing arm 210 and the base 100, but the first swing arm 210 rotates relative to the base 100 through an arc-shaped sliding fit structure. For example, as shown in FIG. 9 and FIG. 10, the base 100 is provided with a first swing groove 110, the first swing body 213 of the first swing arm 210 is provided with a first swing portion 2132, the first swing portion 2132 is slidably assembled in the first swing groove 110, and the first swing portion 2132 is capable of sliding relative to the first swing groove 110 to enable the first swing body 213 to swing. In a process in which the first swing portion 2132 slides relative to the first swing groove 110, the first swing portion 2132 moves along a circular arc-shaped track, to enable the first swing arm 210 to rotate relative to the base 100.

As shown in FIG. 9, the first swing body 213 and the first swing portion 2132 are of an integrated structure, the first swing portion 2132 is located on a side that is of the first swing body 213 and that is close to the base 100, one first swing portion 2132 is disposed on each of a top region and a bottom region of the side of the first swing body 213, and a first sliding portion 214 is mounted on a side that is of the first swing body 213 and that is away from the first swing portion 2132. As shown in FIG. 10, the base 100 is provided with two first swing grooves 110 spaced apart on a region opposite to the first swing arm 210, and two first swing portions 2132 of the first swing body 213 are slidably assembled in the two first swing grooves 110 in one-to-one correspondence. In this setting manner, through cooperation of the two first swing grooves 110 and the two first swing portions 2132, the base 100 limits the first swing arm 210 in the length direction, thereby improving motion stability of the first swing arm 210 in a swing process relative to the base 100 and reducing swing of the first swing arm 210 in the length direction of the base 100.

The rigid portion 330 is fixedly connected to the first swing arm 210, which means that the rigid portion 330 and the first swing arm 210 do not move relative to each other, but does not mean that the rigid portion 330 and the first swing arm 210 are not detachable from each other. The rigid portion 330 may be detachably or non-detachably connected to the first swing arm 210. For example, the rigid portion 330 and the first swing arm 210 may be connected through riveting, adhesion, welding, or the like, or may be connected through a fixing member 400.

In some examples, the rigid portion 330 and the first swing arm 210 are connected through the fixing member 400. In this case, a hinge structure further includes the fixing member 400. The rigid portion 330 is provided with a first fixing hole 3321, the first swing arm 210 is provided with a second fixing hole 211, and the fixing member 400 passes through the first fixing hole 3321 and the second fixing hole 211 to connect the rigid portion 330 to the first swing arm 210. The fixing member 400 may be a bolt, or the fixing member 400 may include a bolt and a nut. When the fixing member 400 is a bolt, one of the first fixing hole 3321 and the second fixing hole 211 is an unthreaded hole, and the other is a threaded hole. The bolt passes through the unthreaded hole and is screwed into the threaded hole, and a head 410 of the bolt is abutted against a structure provided with an unthreaded hole, to connect the first swing arm 210 to the rigid portion 330. When the fixing member 400 includes a bolt and a nut, both the first fixing hole 3321 and the second fixing hole 211 may be unthreaded holes. One end of the bolt passes through the first fixing hole 3321 and the second fixing hole 211 and then extends out of the holes, the nut is screwed onto the bolt, and a head 410 of the bolt and the nut are respectively located on two sides of the rigid portion 330 and the first swing arm 210, to connect the rigid portion 330 to the first swing arm 210, to connect the rigid portion 330 to the first swing arm 210.

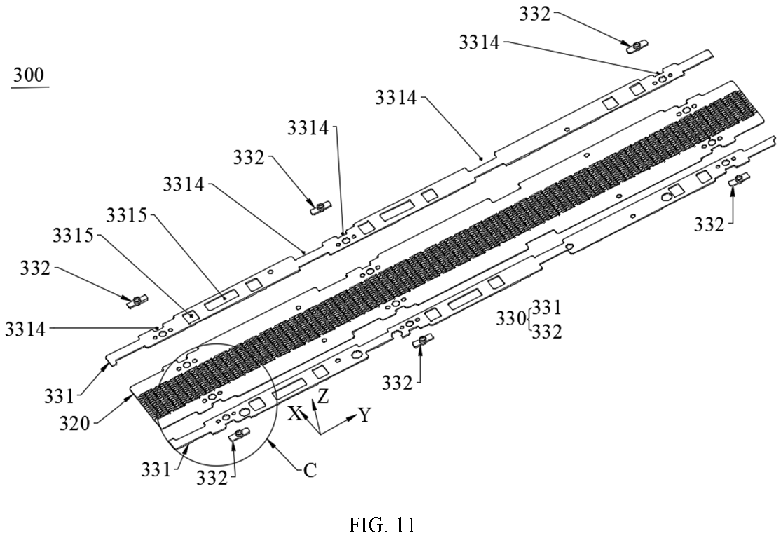

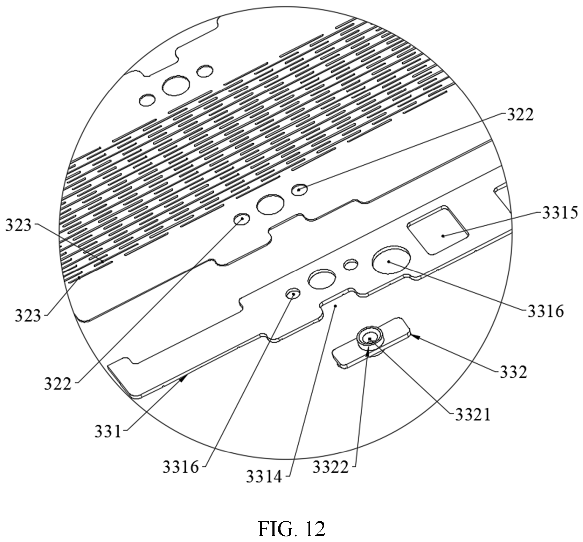

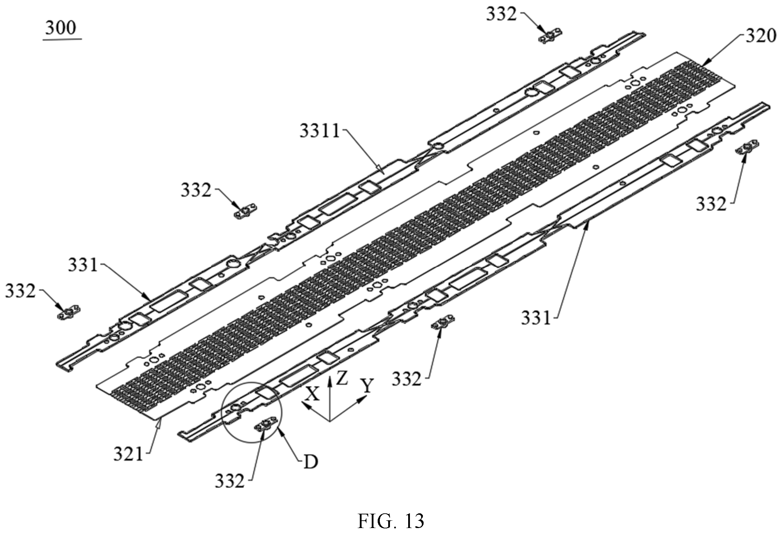

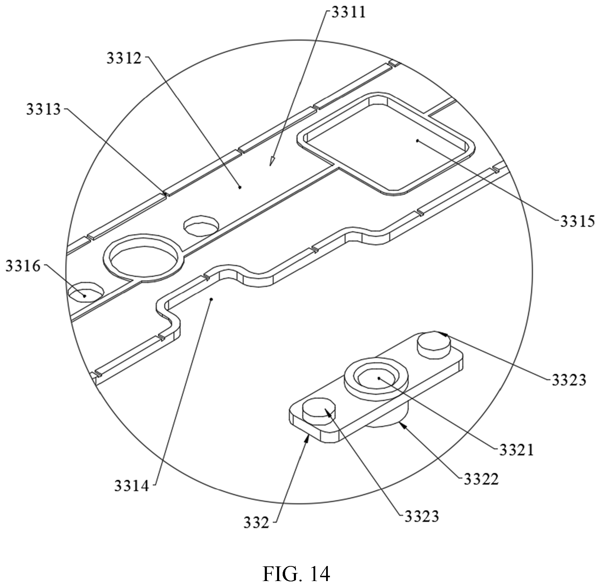

In some embodiments, the rigid portion 330 may be a plate-shaped structure, and a hole is drilled through the plate-shaped structure in a thickness direction to form the first fixing hole 3321. In some other embodiments, as shown in FIG. 11 and FIG. 12, the rigid portion 330 includes a support plate 331 and a fixing base 332, the fixing base 332 is connected to the support plate 331, the fixing base 332 is provided with a fixing column 3322, the first fixing hole 3321 is provided on the fixing column 3322, and at least a part of the fixing column 3322 extends into the second fixing hole 211. In this setting manner, a thickness of the fixing column 3322 may be greater than a thickness of the rigid portion 330. Because the first fixing hole 3321 is disposed on the fixing column 3322, a length of the first fixing hole 3321 is greater than a thickness of the support plate 331, that is, the length of the first fixing hole 3321 is increased, so that a length of a structure in which the fixing member 400 extends into the first fixing hole 3321 can be increased, a length of fitting between the fixing member 400 and the first fixing hole 3321 can be increased, and limiting effect of the first fixing hole 3321 for the fixing member 400 can be improved. When the first fixing hole 3321 is a threaded hole, the length of fitting between the first fixing hole 3321 and the fixing member 400 is increased, so that strength of connection between the fixing member 400 and the fixing column 3322 can be improved. The support plate 331 may be a plastic sheet or a steel sheet, and the fixing base 332 may be made of metal or rigid plastic. The fixing base 332 and the support plate 331 may be connected through welding, gluing, or the like. Alternatively, the fixing base 332 and the support plate 331 may be of an integrated structure. For example, as shown in FIG. 13 and FIG. 14, a through-hole is provided on the support plate 331, two ends of the fixing column 3322 separately protrude from the fixing base 332, and the fixing base 332 is located on a side that is of the support plate 331 and that is away from the flexible portion 320. One end of the fixing column 3322 extends into the through-hole on the support plate 331. The fixing base 332 is connected to the support plate 331 through welding. The other end of the fixing column 3322 extends into the second fixing hole 211. Because one end of the fixing column 3322 extends into the through-hole on the support plate 331, the support plate 331 limits the fixing column 3322 through the through-hole provided on the support plate, and the other end of the fixing column 3322 extends into the second fixing hole 211, a distance between the rigid portion 330 and the first swing arm 210 is closer, thereby making a structure of the rotating shaft mechanism 10 more compact. In addition, an axial length of the second fixing hole 211 may be used to further increase an axial length of the first fixing hole 3321, to further increase a length of a fitting region between the first fixing hole 3321 and the fixing member 400, thereby improving stability of connection between the rigid portion 330 and the first swing arm 210.

In some examples, as shown in FIG. 11 and FIG. 12, the fixing base 332 is provided with a positioning member 3323, the support plate 331 is provided with a first positioning hole 3316, and at least a part of the positioning member 3323 is located in the first positioning hole 3316. In this setting manner, disposition of the first positioning hole 3316 and the positioning member 3323 is conducive to quickly adjusting the fixing base 332 to a correct position, thereby helping improve assembly efficiency. In addition, mutual cooperation between the first positioning hole 3316 and the positioning member 3323 causes relative limitation between the fixing base 332 and the support plate 331, thereby facilitating connection between the fixing base 332 and the support plate 331. The positioning member 3323 may be cylindrical, prismatic, spherical, or of any other shape. A shape of the first positioning hole 3316 matches a shape of the positioning member 3323, so that an inner wall of the first positioning hole 3316 limits the positioning member 3323.

In some embodiments, the fixing base 332 may be provided with one or more positioning members 3323, and the support plate 331 is provided with a plurality of first positioning holes 3316. The plurality of first positioning holes 3316 are disposed in one-to-one correspondence with the plurality of positioning members 3323, and each positioning member 3323 is inserted into a corresponding first positioning hole 3316. For example, the fixing base 332 is provided with two positioning members 3323, and the two positioning members 3323 are spaced apart on one side that is of the fixing base 332 and that faces the support plate 331. The support plate 331 is provided with two first positioning holes 3316, and each positioning member 3323 is inserted into a corresponding first positioning hole 3316.

Optionally, there may be a plurality of fixing bases 332. For example, there are six fixing bases 332. As shown in FIG. 11 and FIG. 12, each support plate 331 is correspondingly provided with three fixing bases 332, and the three fixing bases 332 are spaced apart in a first direction. One fixing base 332 is connected to the bottom of the support plate 331, another fixing base 332 is connected to the middle of the support plate 331, and the last fixing base 332 is connected to the top of the support plate 331. The support plate 331 is correspondingly provided with three first fixing holes 3321, the three first fixing holes 3321 are disposed in one-to-one correspondence with fixing columns 3322 on the three fixing bases 332, and each fixing column 3322 is inserted into a corresponding first fixing hole 3321. Each support plate 331 is further provided with six first positioning holes 3316, every two first positioning holes 3316 correspond to two positioning members 3323 on one fixing base 332, and the positioning member 3323 is inserted into a corresponding first positioning hole 3316.

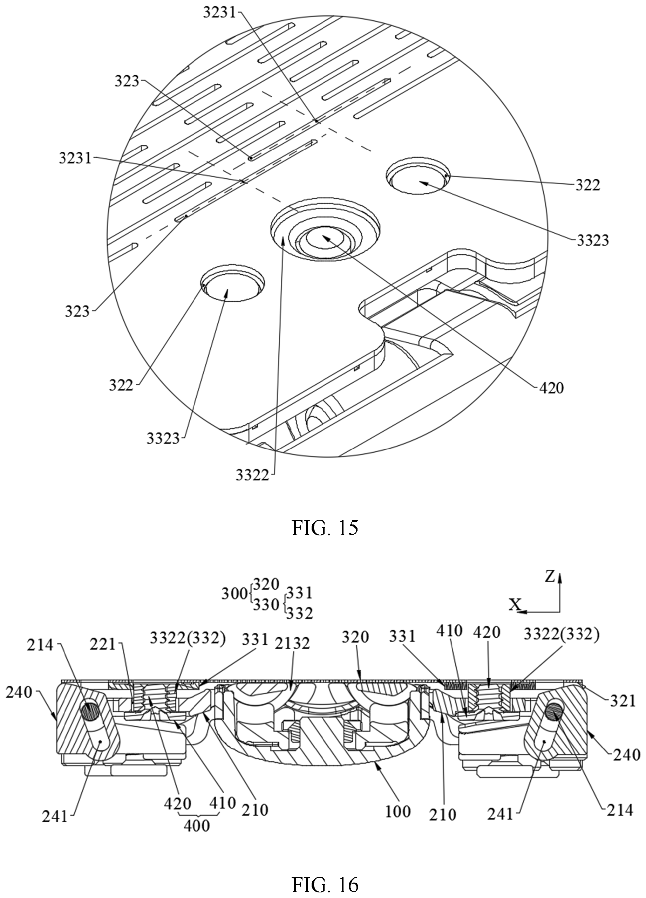

In some examples, as shown in FIG. 12 and FIG. 15, the flexible portion 320 is provided with a second positioning hole 322, and the second positioning hole 322 is disposed opposite to the first positioning hole 3316. In some embodiments, an end that is of the positioning member 3323 and that is close to the flexible portion 320 may be spaced apart from the second positioning hole 322 in a Z-axis direction, that is, the end that is of the positioning member 3323 and that is close to the flexible portion 320 may be spaced apart from the first surface 321 of the flexible portion 320 in the Z-axis direction. In this way, in an assembly process, whether the positioning member 3323 is accurately inserted into the first positioning hole 3316 can be observed through the second positioning hole 322, thereby improving assembly stability of the fixing base 332. Alternatively, in some other embodiments, an end that is of the positioning member 3323 and that is close to the flexible portion 320 may extend into the second positioning hole 322. The positioning member 3323 is limited by both the second positioning hole 322 and the first positioning hole 3316, thereby further improving assembly stability of the fixing base 332 and improving stability of connection between the flexible portion 320 and the rigid portion 330.

In some embodiments, when there are a plurality of fixing bases 332, and each fixing base 332 is provided with a plurality of positioning members 3323, the support plate 331 is provided with a plurality of first positioning holes 3316 corresponding to the plurality of positioning members 3323, the flexible portion 320 is provided with a plurality of second positioning holes 322 corresponding to the plurality of positioning members 3323, and the positioning members 3323 on each fixing base 332 respectively correspond to one first positioning hole 3316 and one second positioning hole 322. The positioning member 3323 is at least inserted into a corresponding first positioning hole 3316 and is disposed corresponding to the corresponding first positioning hole 3316. For example, as shown in FIG. 11, each support plate 331 is correspondingly provided with three fixing bases 332, and the three fixing bases 332 are spaced apart in a first direction. Each fixing base 332 is provided with two positioning members 3323, there are six second positioning holes 322 passing through each flexible portion 320 in a thickness direction of the flexible portion 320, the six second positioning holes 322 are disposed in one-to-one correspondence with the positioning members 3323 on the three fixing bases 332, and each positioning member 3323 is inserted into a corresponding second positioning hole 322.

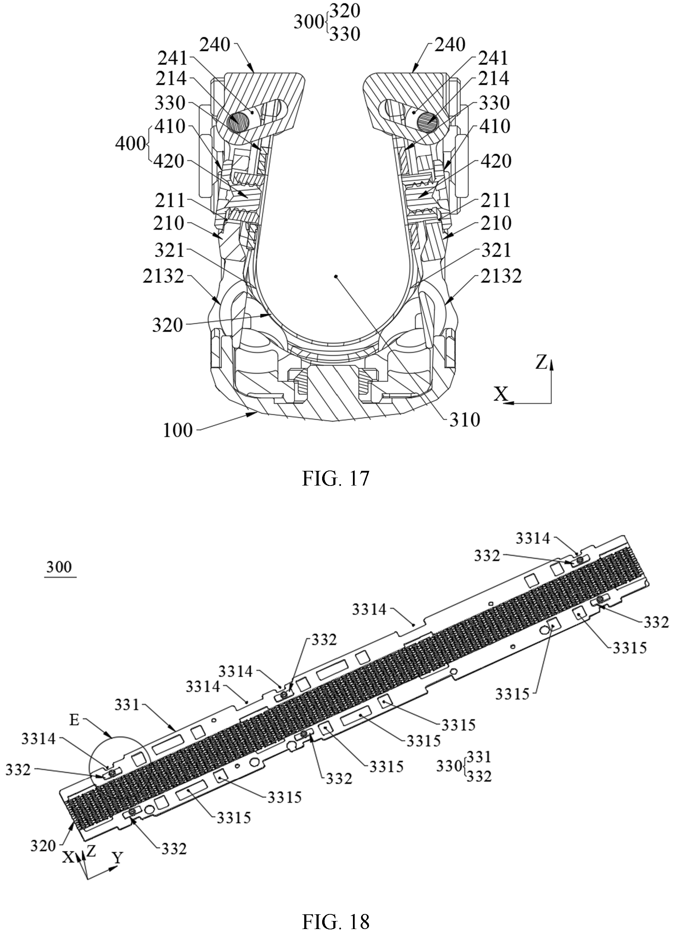

In some examples, as shown in FIG. 16 and FIG. 17, the first fixing hole 3321 is a threaded hole, the second fixing hole 211 is a countersunk hole, the fixing member 400 includes a head 410 and a threaded portion 420 that are connected to each other, the head 410 is located in the countersunk hole, and the threaded portion 420 is located in the threaded hole. The threaded portion 420 of the fixing member 400 passes through the countersunk hole and is connected to the threaded hole, and the head 410 of the fixing member 400 is located in the countersunk hole, so that the rigid portion 330 is stably connected to the first swing arm 210. In this setting manner, the fixing member 400 may be a structure such as a screw or a bolt. The countersunk hole is disposed to accommodate the head 410 of the fixing member 400, so that a space occupied by the fixing member 400 is reduced to some extent, thereby reducing a space occupied by the rotating shaft mechanism 10.

The rigid portion 330 and the flexible portion 320 may be connected through adhesive bonding, welding, clamping, screwing, or the like. Optionally, the rigid portion 330 and the flexible portion 320 are connected through adhesive bonding. Through adhesive bonding, the rigid portion 330 and the flexible portion 320 may be connected in entire contact planes, thereby enlarging a region of connection between the rigid portion 330 and the flexible portion 320 and helping improve strength of connection between the rigid portion 330 and the flexible portion 320. In some examples, as shown in FIG. 13 and FIG. 14, the rigid portion 330 has a second surface 3311 facing the first surface 321, and the second surface 3311 is provided with an adhesive accommodating groove 3312. In other words, the adhesive accommodating groove 3312 is provided on a side that is of the rigid portion 330 and that faces the flexible portion 320, and the adhesive accommodating groove 3312 is used for adhesive accommodation. In this way, adhesive between the rigid portion 330 and the flexible portion 320 has a particular thickness, thereby helping improve strength of connection between the rigid portion 330 and the flexible portion 320. In a specific embodiment, the second surface 3311 is specifically a side that is of the support plate 331 in the rigid portion 330 and that faces the first surface 321, that is, the adhesive accommodating groove 3312 is specifically disposed on the side that is of the support plate 331 in the rigid portion 330 and that faces the flexible portion 320, thereby improving strength of connection between the support plate 331 and the flexible portion 320.

In some examples, the second surface 3311 is provided with an adhesive overflow groove 3313, and the adhesive overflow groove 3313 communicates with the adhesive accommodating groove 3312. The adhesive overflow groove 3313 is disposed, so that redundant adhesive flows out through the adhesive overflow groove 3313. The adhesive overflow groove 3313 is specifically disposed on the side that is of the support plate 331 in the rigid portion 330 and that faces the flexible portion 320. In some embodiments, there may be a plurality of adhesive overflow grooves 3313, and the plurality of adhesive overflow grooves 3313 are spaced apart in an edge region of the second surface 3311. As shown in FIG. 13 and FIG. 14, an annular peripheral side wall is disposed in the edge region of the second surface 3311, and the peripheral side wall and the second surface 3311 enclose to form the foregoing adhesive accommodating groove 3312. Each adhesive overflow groove 3313 extends through the peripheral side wall in a thickness direction of the peripheral side wall, so that the adhesive accommodating groove 3312 communicates with the outside through the adhesive overflow groove 3313, thereby facilitating outflow of redundant adhesive in the adhesive accommodating groove 3312 through the adhesive overflow groove 3313.

In some examples, an avoidance opening 3314 is disposed at an edge of the rigid portion 330. The avoidance opening 3314 is configured to avoid another structure mounted on the base 100, such as the first swing arm 210, the second swing arm 220, the third swing arm 230, or the adapter structure 240. Alternatively, the avoidance opening 3314 may be configured to avoid a partial structure of the base 100, for example, a protrusion structure protruding from a surface of the base 100. Disposition of the avoidance opening 3314 helps improve structural compactness of the rotating shaft mechanism 10. The avoidance opening 3314 is specifically disposed in an edge region of the support plate 331 in the rigid portion 330. In some implementations, there may be a plurality of avoidance openings 3314, and the plurality of avoidance openings 3314 are spaced apart at the edge of the support plate 331. As shown in FIG. 11 and FIG. 12 or FIG. 18 and FIG. 19, there are a plurality of avoidance openings 3314, and the plurality of avoidance openings 3314 are spaced apart on two opposite sides of the support plate 331 in a second direction. Shapes of the avoidance openings 3314 may be different. A shape and a size of each avoidance opening 3314 specifically match a shape and a size of a corresponding avoidance structure, to help the avoidance opening 3314 accommodate the corresponding avoidance structure, thereby achieving an avoidance function of the avoidance opening 3314 and improving structural compactness of the rotating shaft mechanism 10.

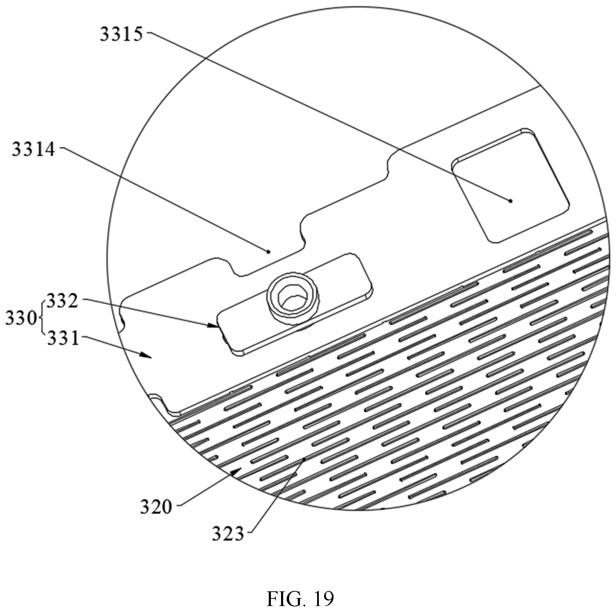

In some examples, the rigid portion 330 is provided with a weight-reducing hole 3315. The weight-reducing hole 3315 is disposed, so that a weight of the rigid portion 330 is reduced to some extent, thereby reducing a weight of the foldable electronic device 1 using the rotating shaft mechanism 10 provided in embodiments of this application. In addition, when the rigid portion 330 is manufactured through injection molding or casting, disposition of the weight-reducing hole 3315 can reduce material of the rigid portion 330, thereby reducing production costs. The weight-reducing hole 3315 is specifically disposed on the support plate 331 of the rigid portion 330. The weight-reducing hole 3315 may be specifically a through-hole or a blind-hole. In some embodiments, there may be one or more weight-reducing holes 3315. The weight-reducing hole 3315 may be a circular hole, a square hole, or a hole of any other shape. This is not limited herein. As shown in FIG. 18 and FIG. 19, each support plate 331 is provided with eight weight-reducing holes 3315, and the eight weight-reducing holes 3315 are spaced apart on the support plate 331 in a first direction.

In some examples, a plurality of hole structures 323 are disposed on the flexible portion 320, a length direction of the hole structure 323 is a first direction, and the first direction is parallel to a rotation axis of the first swing arm 210. The hole structure 323 may be a circular hole, an elliptical hole, a square hole, a racetrack hole, or a hole of another shape. The plurality of hole structures 323 are disposed on the flexible portion 320, so that bending stress of the flexible portion 320 can be reduced, and flexibility of the flexible portion 320 is improved, thereby making the flexible portion 320 more easily bend. The hole structure 323 may be a blind hole or a through hole. When the hole structure 323 is a blind hole, a thickness of of a position of the blind hole in the flexible portion 320 is less than a thickness of another region of the flexible portion 320, and an opening of the blind hole may be located on a side that is of the flexible portion 320 and that is away from the base 100. In some embodiments, the flexible portion 320 is made of a thin steel sheet, and a plurality of hole structures 323 are disposed on the flexible portion 320, so that a region in which the plurality of hole structures 323 are disposed on the flexible portion 320 has particular elasticity. Therefore, the flexible portion 320 can stretch and contract during bending, and the flexible portion 320 can adapt to an change of an arc length after being bent, to help the flexible portion 320 form a U-shaped or water-drop-shaped avoidance space 310 after being bent, thereby protecting the display.

In some examples, the flexible portion 320 is provided with a plurality of hole structures 323 spaced apart in the first direction, the plurality of hole structures 323 spaced apart in the first direction form one hole group, the flexible support structure 300 is provided with a plurality of hole groups spaced apart in a second direction, and the second direction is at an angle to the first direction. It can be learned that the flexible portion 320 is provided with the plurality of hole structures 323 spaced apart in both the first direction and the second direction, thereby helping the flexible portion 320 bend in the first direction. The second direction may be at any angle to the first direction. In an example, the second direction is perpendicular to the first direction.

In some examples, hole structures 323 in two adjacent hole groups are staggered at a center point 3231 of the first direction. In this way, a distance between two adjacent hole structures 323 can be increased in a width direction, thereby improving structural strength of the flexible portion 320. In a specific example, the hole structure 323 has a plurality of side walls, and has at least two first side walls that are spaced apart in the first direction and two second side walls that are spaced apart in the second direction. The two first side walls and the two second side walls enclose an empty cavity, and a center of the empty cavity is a position of the center point 3231 of the hole structure 323. As shown in FIG. 15, for ease of showing the position of the center point 3231 of the hole structure 323, the center point 3231 of the hole structure 323 is shown in the figure by using an intersection of two intersecting dashed lines. In the two intersecting dashed lines, one dashed line is parallel to a length direction of the hole structure 323, and the other dashed line is parallel to a width direction of the hole structure 323. Distances from the center point 3231 of the hole structure 323 to the two first side walls in the first direction are equal, and distances from the center point 3231 of the hole structure 323 to the two second side walls in the second direction are equal.

In some examples, the hole structure 323 penetrates the flexible portion 320 in a thickness direction of the flexible portion 320. In other words, the hole structure 323 is a through-hole. In this way, bending stress at a place in which the hole structure 323 is disposed in the flexible portion 320 is further reduced, so that a region in which the plurality of hole structures 323 are disposed in the flexible portion 320 is more easily bent.

The foregoing embodiments are merely intended to describe the technical solutions of this application, rather than limit this application. Although this application is described in detail with reference to the foregoing embodiments, a person of ordinary skill in the art should understand that modifications can still be made to the technical solutions described in the foregoing embodiments or equivalent replacements can be made to some technical features thereof, without departing from the spirit and scope of the technical solutions of embodiments of this application. All these modifications and equivalent replacements shall fall within the protection scope of this application.

## Claims

1. A rotating shaft mechanism, comprising:
a base;
a first swing arm, wherein there are at least two first swing arms, at least one first swing arm is rotatably mounted on each of two sides of the base, and the first swing arm is capable of rotating relative to the base to enable the rotating shaft mechanism to switch between a folded state and an unfolded state; and
a flexible support structure, comprising a flexible portion and a rigid portion, wherein the flexible portion is located on a side of the base in a thickness direction, the flexible portion has a first surface facing the base, the rigid portion is connected to each of two sides of the first surface, the rigid portion is connected to a corresponding first swing arm, and the flexible portion is configured to form an avoidance space when the rotating shaft mechanism is in a folded state.

2. The rotating shaft mechanism according to claim 1, wherein the rigid portion is provided with a first fixing hole, the first swing arm is provided with a second fixing hole, the rotating shaft mechanism further comprises a fixing member, and the fixing member passes through the first fixing hole and the second fixing hole to connect the rigid portion to the first swing arm.

3. The rotating shaft mechanism according to claim 2, wherein the rigid portion comprises a support plate and a fixing base, the fixing base is connected to the support plate, the fixing base is provided with a fixing column, the first fixing hole is provided on the fixing column, and at least a part of the fixing column extends into the second fixing hole.

4. The rotating shaft mechanism according to claim 3, wherein the fixing base is provided with a positioning member, the support plate is provided with a first positioning hole, and at least a part of the positioning member is located in the first positioning hole.

5. The rotating shaft mechanism according to claim 4, wherein the flexible portion is provided with a second positioning hole, and the second positioning hole is disposed opposite to the first positioning hole.

6. The rotating shaft mechanism according to claim 3, wherein the first fixing hole is a threaded hole, the second fixing hole is a countersunk hole, the fixing member comprises a head and a threaded portion that are connected to each other, the head is located in the countersunk hole, and the threaded portion is located in the threaded hole.

7. The rotating shaft mechanism according to claim 1, wherein the rigid portion has a second surface facing the first surface, and the second surface is provided with an adhesive accommodating groove.

8. The rotating shaft mechanism according to claim 7, wherein the second surface is provided with an adhesive overflow groove, and the adhesive overflow groove communicates with the adhesive accommodating groove.

9. The rotating shaft mechanism according to claim 1, wherein an avoidance opening is disposed at an edge of the rigid portion.

10. The rotating shaft mechanism according to claim 1, wherein the rigid portion is provided with a weight-reducing hole.

11. The rotating shaft mechanism according to any one of claims 1 to 10, wherein a plurality of hole structures are disposed on the flexible portion, a length direction of the hole structure is a first direction, and the first direction is parallel to a rotation axis of the first swing arm.

12. The rotating shaft mechanism according to claim 11, wherein the flexible portion is provided with a plurality of hole structures spaced apart in the first direction, the plurality of hole structures spaced apart in the first direction form one hole group, the flexible support structure is provided with a plurality of hole groups spaced apart in a second direction, and the second direction is at an angle to the first direction.

13. The rotating shaft mechanism according to claim 12, wherein hole structures in two adjacent hole groups are staggered at a center point of the first direction.

14. The rotating shaft mechanism according to claim 11, wherein the hole structure penetrates the flexible portion in a thickness direction of the flexible portion.

15. The rotating shaft mechanism according to any one of claims 1 to 14, wherein the rotating shaft mechanism is further provided with an adapter structure, the adapter structure is slidably connected to the first swing arm, the adapter structure is rotatably connected to the base, and the adapter structure is configured to drive the first swing arm to rotate and make a rotation angle of the first swing arm greater than a rotation angle of the adapter structure, so that the flexible portion bends under driving of the first swing arm to form a water-drop-shaped avoidance space.

16. The rotating shaft mechanism according to claim 15, wherein the adapter structure is provided with a first sliding hole, the first swing arm is provided with a first sliding portion, and the first sliding portion is slidably assembled in the first sliding hole.

17. The rotating shaft mechanism according to claim 16, wherein the first swing arm comprises a first swing body and the first sliding portion, the first swing body is provided with a first through-hole, the first sliding portion passes through the first through-hole and is connected to the first swing body, and at least a part of structure that is of the first sliding portion and that is located outside the first through-hole is located in the first sliding hole.

18. The rotating shaft mechanism according to claim 17, wherein there are two first through-holes, the two first through-holes are respectively located on two sides of the first sliding hole, the two first through-holes are coaxially disposed, and two ends of the first sliding portion are respectively located in the two first through-holes.

19. The rotating shaft mechanism according to claim 17, wherein the first swing body is provided with a first swing portion, the base is provided with a first swing groove, the first swing portion is slidably assembled in the first swing groove, and the first swing portion is capable of sliding relative to the first swing groove to enable the first swing body to swing.

20. A foldable electronic device, comprising a first housing, a second housing, a display, and the rotating shaft mechanism according to any one of claims 1 to 19, wherein the rotating shaft mechanism is connected between the first housing and the second housing, the display is disposed on one side of the first housing, the second housing, and the rotating shaft mechanism, the display is located on a side that is of the flexible portion in the rotating shaft mechanism and that is away from the base, and at least a part of the display is located in the avoidance space when the rotating shaft mechanism is in a folded state.
